# EUROPEAN PATENT SPECIFICATION

(11) **EP 1 347 830 B1**
(45) Date of publication and mention of the grant of the patent: **20.08.2008**
(21) Application number: 01998400.4
(22) Date of filing: 29.11.2001
(51) Int. Cl.: B01J 19/12, C02F 1/48

(54) **MINIATURE APPARATUS FOR DELIVERING ELECTROMAGNETIC ENERGY INTO A SOLUTION**
MINIATURVORRICHTUNG ZUR ZUFÜHRUNG VON ELEKTROMAGNETISCHER ENERGIE IN EINE LÖSUNG
APPAREIL MINIATURE POUR FOURNIR UNE ENERGIE ELECTROMAGNETIQUE DANS UNE SOLUTION

(30) Priority: 29.11.2000 IE 20000971
(43) Date of publication of application: 01.10.2003
(73) Proprietor: Darragh, Austin, Dunsany, County Meath (IE); Darragh, David, County Dublin (IE)
(72) Inventor: Darragh, Austin, Dunsany, County Meath (IE); Darragh, David, County Dublin (IE)
(74) Representative: McCarthy, Denis Alexis
(86) International application number: PCT/IE2001/000149
(87) International publication number: WO 2002/043857

(56) References cited:
- EP-A- 0 580 320
- WO-A-00/33954
- WO-A-98/11022
- DE-A- 3 836 155
- DE-U- 29 715 698
- GB-A- 852 733
- US-A- 4 865 747
- US-A- 5 682 774

## Description

The present invention relates to an apparatus for delivering electromagnetic energy into a solution and in particular to a miniature version which can easily be transported and can be used for many applications where it is desired to deliver electromagnetic energy into a solution to modify its characteristics such as Zeta potential.

WO-A-9622831 discloses an apparatus for delivering electromagnetic energy into a solution. Preferred embodiments of delivery apparatus disclosed in this prior art document comprise a tubular housing having closed ends and forming a water tight chamber, a coil contained within the chamber delivering a magnetic field into a solution, at least one electric field probe coupled to the coil for delivering an electric field into the solution and coupling means for coupling an electromagnetic signal to the coil.

This apparatus is very useful for treating large volumes of a solution, usually water, however the apparatus is only suitable for a large installation and is not suitable for use in many situations and is not readily transportable.

The present invention provides an apparatus for delivering electromagnetic energy into a solution comprising a power source, an oscillator crystal means for generating an electromagnetic signal such as a radio frequency (RF) signal, and an antenna for transmitting the generated signal into a solution **characterised in that** the antenna is an elongate wire, the length of which approximates to one sixteenth of the wavelength of the RF signal generated by the oscillator crystal means.

The power source may be a battery, a DC mains adapter, a rechargeable battery or a rechargeable battery with a backup battery, or a rechargeable battery with a DC generator powered by water flow.

Conveniently, the apparatus includes an indicator for indicating that the battery is charging when a rechargeable battery is used as a power source.

Conveniently, the apparatus includes a zener diode to regulate the voltage applied across the oscillator crystal means.

Conveniently, the apparatus includes a buffer chip to regulate the output of the oscillator crystal means to the antenna.

Preferably, the apparatus includes a switch and a separate means for indicating when the apparatus is operating and optionally includes one or more diodes to allow current to flow in one direction and to protect a rechargeable battery from being improperly charged. The antenna may be an elongate wire the length of which approximates to a fractional length of the RF signal generated by the oscillator crystal means, can include a brass ball, at its end and an optional covering element and may be locatable along the inside of a pipe used tn supply water.

Conveniently, the filter is operable to keep the output frequency to a constant value within the range 27.225 MHz to 27.255 MHz.

The invention will hereinafter be more particularly described with reference to the accompanying drawings which show, by way of example only, a number of embodiments in accordance with the invention.

In the drawings: -
- Figure 1: is a circuit diagram of a first embodiment of an apparatus for delivering electromagnetic energy into a solution;
- Figure 2: is a circuit diagram of a second embodiment of an apparatus according to the invention; the second embodiment having a power on light, a back-up battery and power on switch;

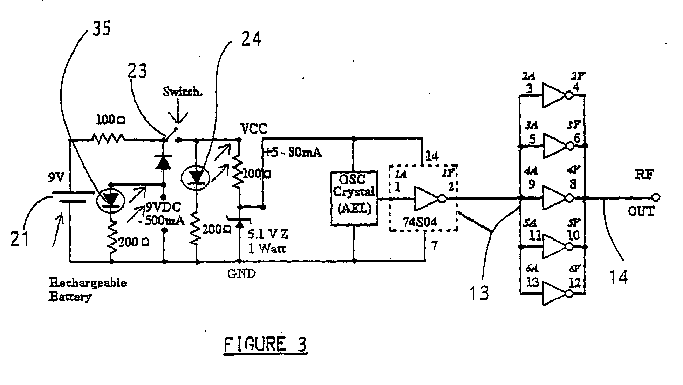

- Figure 3: is a circuit diagram of a third embodiment of apparatus according to the invention, which includes an indicator to indicate that a mains adapter powers tbc unit;

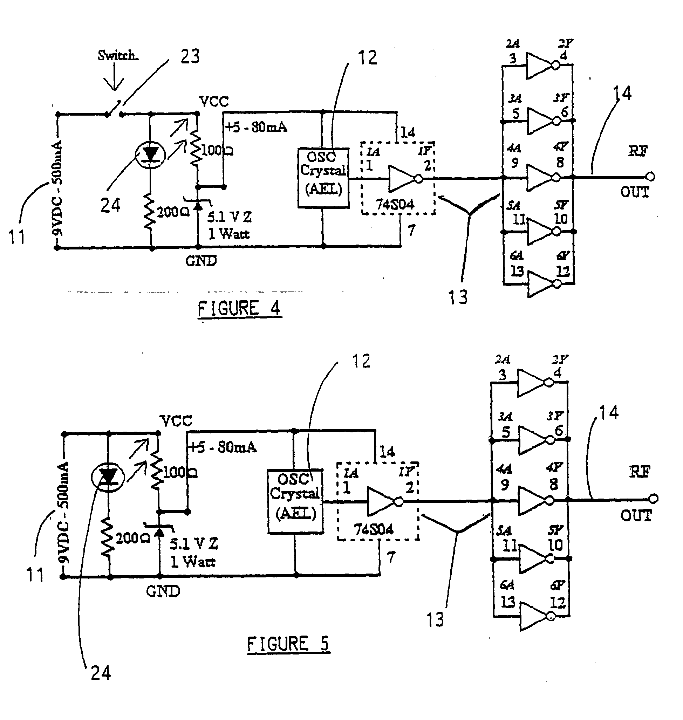

- Figure 4: is a circuit diagram of a fourth embodiment of apparatus according to the invention, similar to the first embodiment but having a power on indicator and a switch;
- Figure 5: is a circuit diagram of a fifth embodiment of apparatus according to the invention similar to the first embodiment with a power on indicator;

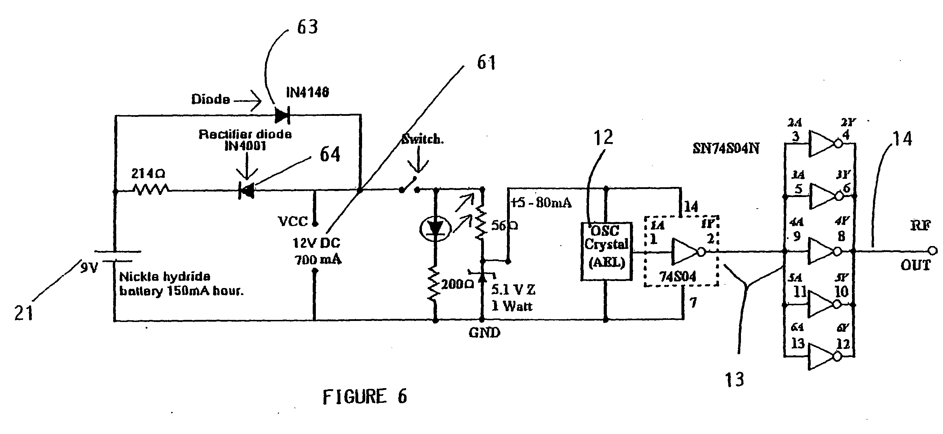

- Figure 6: is a circuit diagram of a sixth embodiment of apparatus according to the invention;
- Figure 7: is a circuit diagram of a seventh embodiment of apparatus according to the invention which combines the features of the first six embodiments.
- Figure 8: is a circuit diagram of an eighth embodiment of apparatus according to the invention which is a modification of the seventh embodiment; and
- Figure 9: is a circuit diagram of a ninth embodiment of apparatus according to the invention which is a further modification of the seventh embodiment.

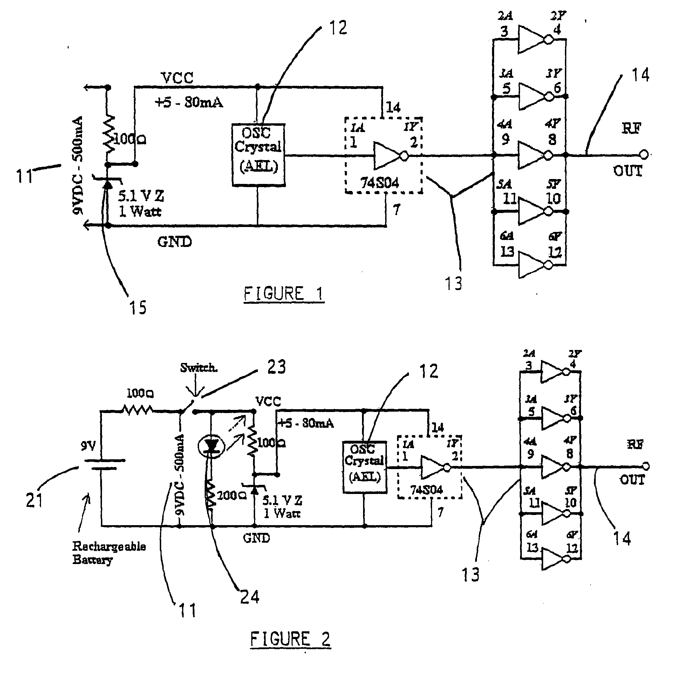

Referring to the drawings and initially to Figure 1, the first embodiment 10 of apparatus for delivering electromagnetic energy into a solution comprises a 9V mains adapter 11, an oscillator crystal 12, a buffer chip 13 and an antenna 14. A Zener diode 15 allows only 5.1 volts to pass through as the oscillator crystal 12 only requires a supply voltage of 5 volts ± 0.1 volts. The oscillator crystal is the main component of the apparatus and in this particular embodiment outputs a radio frequency signal of 20 MHz which is sent through the buffer chip 13 to the antenna 14. Similar components in the other embodiments are given similar numbers as in the first embodiment.

The second embodiment 20 is similar to the first embodiment, except that it includes a rechargeable battery 21 as well as the 9V mains adapter 11. Battery 21 acts as a backup power source. It also includes a switch 23 and a light emitting diode (LED) 24 which emits light when the switch 23 is closed and the unit is operating.

The third embodiment 30 is similar to the second embodiment 20 but includes a separate LED 35 which is used to indicate that the unit is being powered by a mains adapter. The LED 35 emits a red light to distinguish it from the LED 24 which emits a green light.

The fourth embodiment 40 includes a 9V mains adapter power supply 11, an LED 24 for indicating power on and a switch 23 for operating the unit.

The fifth embodiment 50 is similar to the first embodiment 10 and includes a power on light LED 24.

The sixth embodiment 60 is similar to the second embodiment 20 but includes a mains adapter 61 which gives a 12V DC supply of 700 mA. It has a power supply socket (not shown) which accepts a jack plug from the adapter. The circuit also includes two diodes 63 and 64 which only allow current to flow in the direction which it is pointed. Diode 63 enables the battery 21 to drive the main circuit when the mains adapter 61 is not charging or plugged into the apparatus. Diode 63 also protects the battery from being improperly charged when adapter 61 is plugged in and operating the circuit.

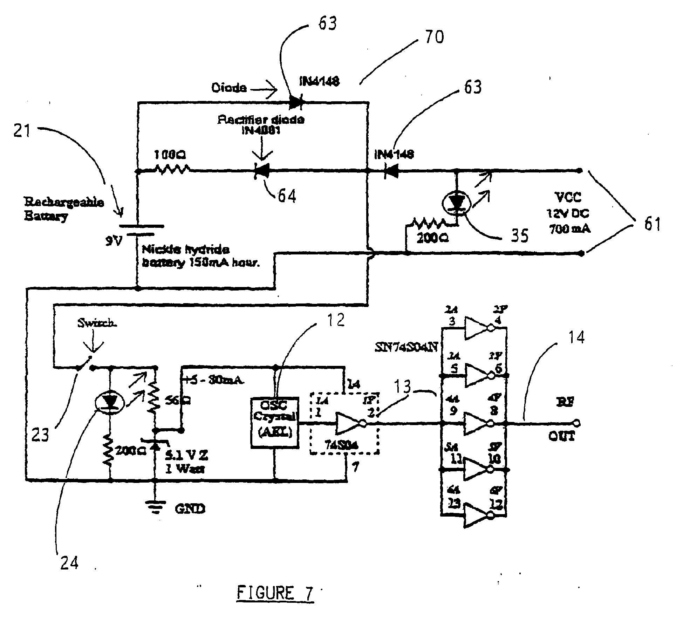

The seventh embodiment 70 shown in Figure 7 includes the majority of the components used in the first six embodiments, namely a rechargeable battery 21, a crystal oscillator 12, a buffer chip 13, an antenna 14, a switch 23, an LED 24, an LED 35, a mains adapter 61, 3 diodes 63, 63(a) and a diode 64. Diode 63(a) only allows LED 35 to illuminate when the mains adapter 61 is plugged into the apparatus.

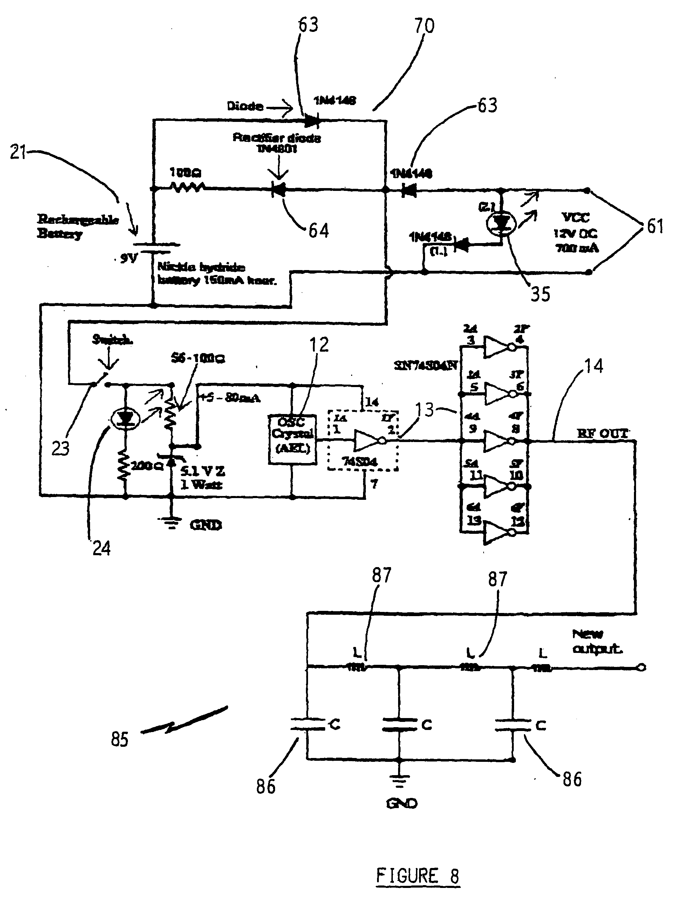

The eighth embodiment 80 shown in Figure 8 is similar to the seventh embodiment 70 except that it has an output modified by filter circuit 85 to reduce secondary and tertiary harmonics so as to reduce interference with other wavelengths and keep the output frequency to a constant value which in the eighth embodiment in the range 27.225 MHz to 27.255 MHz The filter circuit 85 includes three capacitors 86 and three impedances 87.

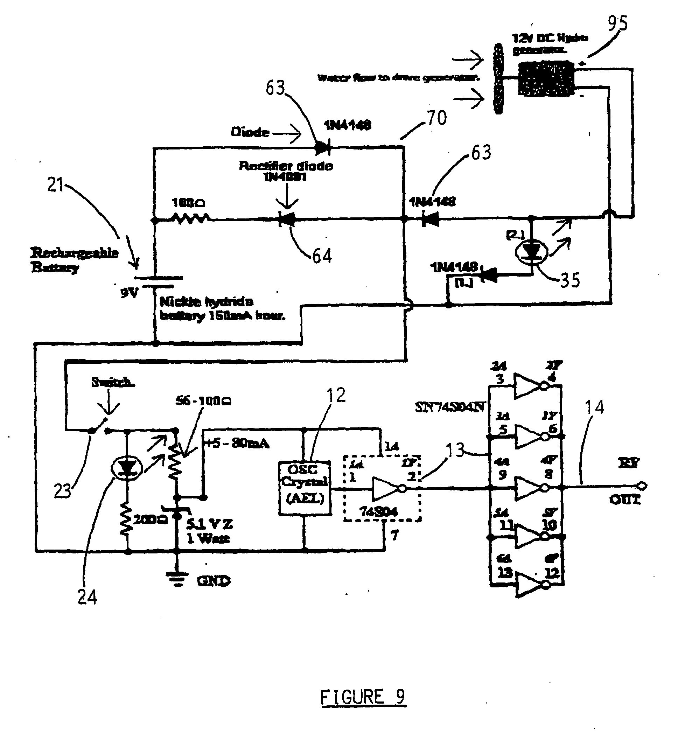

The ninth embodiment 90 shown in Figure 9 is also similar to the seventh embodiment 70 except that it has a generator 95 for generating a DC supply from the flow of water which is used to recharge battery 21.

In relation to all of the above embodiments, the antenna 14 is an elongate wire which in the particular embodiments used is 0.889 m in length which approximates to 1/16 of the particular wavelength of the RF signal generated by the crystal oscillator 12. In a modification (not shown) the antenna has a brass ball on the end of it with a cover.

The apparatus according to the invention has numerous applications; it can be used to treat water used to irrigate plants and flowers. The antenna can extend along the inside of a hosepipe used to supply water to the plants. It can be demonstrated that it enhances plant growth by achieving higher yields of fruit, vegetables, plants, flowers, shrubs, trees and other plant life. The apparatus can also be used to treat water used in domestic applications, it helps prevent or eliminate scaling in kettles, coffee making machines, taps, faucets and showerheads.

It will of course be understand that the invention is not limited to the specific details described herein, which are given by way of example only and that various modifications and alterations may be made without departing from the scope of the invention as defined in the appended claims.

## Claims

1. An apparatus for delivering electromagnetic energy into a solution comprising:
a power source;
an oscillator crystal means for generating an electromagnetic signal such as a radio frequency (RF) signal; and
an antenna for transmitting the generated signal into the solution **characterised in that** the antenna is an elongate wire, the length of which approximates to one sixteenth of the wavelength of the RF signal generated by the oscillator crystal means.

2. An apparatus for delivering electromagnetic energy into a solution as claimed in Claim 1, in which the power source is selected from one of the following:-
a battery;
a DC mains adapter;
a rechargeable battery;
a rechargeable battery with a backup battery; or
a rechargeable battery with a DC generator powered by water flow.

3. An apparatus for delivering electromagnetic energy into a solution as claimed in Claim 2, which includes means for indicating that a battery is charging when a rechargeable battery is used as a power source.

4. An apparatus for delivering electromagnetic energy into a solution as claimed in any one of the preceding claims, including a zener diode to regulate the voltage applied across the oscillator crystal means.

5. An apparatus for delivering electromagnetic energy into a solution as claimed in any one of the preceding claims, including a buffer chip to regulate the output of the oscillator crystal means to the antenna.

6. An apparatus for delivering electromagnetic energy into a solution as claimed in any one of the preceding claims, including a switch and a separate means for indicating when the apparatus is operating.

7. An apparatus for delivering electromagnetic energy into a solution as claimed in any one of the preceding claims, including one or more diodes to allow current to flow in one direction and to protect a rechargeable battery from being improperly charged.

8. An apparatus for delivering electromagnetic energy into a solution as claimed in Claim 7, in which the antenna is provided with a brass ball at its end and an optional covering element.

9. An apparatus for delivering electromagnetic energy into a solution as claimed in any one of the preceding claims including a filter to reduce or eliminate secondary or tertiary harmonics from the output of the generated signal.

10. An apparatus for delivering electromagnetic energy into a solution as claimed in any one of the preceding claims, in which the antenna is locatable along the inside of a pipe used to supply water.

11. An apparatus for delivering electromagnetic energy into a solution as claimed in Claim 10, in which the water pipe delivers water for irrigating plant life such as grass, fruit, vegetables, blooms, shrubs and trees.

12. An apparatus for delivering electromagnetic energy into a solution as claimed in Claim 9, in which the water pipe delivers water for use in domestic applications, whereby the apparatus helps prevent or eliminate scaling in kettles, coffee making machines, taps, faucets, shower heads and the like.

13. An apparatus for delivering electromagnetic energy into a solution as claimed in any one of Claims 9 to 12 in which the filter is operable to keep the output frequency to a constant value within the range 27.225 MHz to 27.255 MHz.

14. A method for treating water by delivering electromagnetic energy into the water using apparatus as claimed in any one of the preceding claims.

## Patentansprüche

1. Vorrichtung zur Zuführung elektromagnetischer Energie in eine Lösung, umfassend:
eine Kraftquelle;
ein Oszillatorkristallmittel zur Erzeugung eines elektromagnetischen Signals, wie etwa eines Hochfrequenz (HF) -Signals; und
eine Antenne zum Übertragen des erzeugten Signals in die Lösung, **dadurch gekennzeichnet, dass** die Antenne ein langgestreckter Draht ist, dessen Länge ungefähr einem Sechzehntel der Wellenlänge des von dem Oszillatorkristallmittel erzeugten HF-Signals entspricht.

2. Vorrichtung zur Zuführung elektromagnetischer Energie in eine Lösung, wie in Anspruch 1 beansprucht, wobei die Kraftquelle aus einem der folgenden gewählt ist:-
einer Batterie;
einem Gleichstrom-Netzadapter;
einer aufladbaren Batterie;
einer aufladbaren Batterie mit einer Backup-Batterie; und
einer aufladbaren Batterie mit einem Gleichstromgenerator, der durch Wasserfluss angetrieben wird.

3. Vorrichtung zur Zuführung elektromagnetischer Energie in eine Lösung, wie in Anspruch 2 beansprucht, welche Mittel zum Anzeigen dessen, dass eine Batterie lädt, wenn eine aufladbare Batterie als Kraftquelle verwendet wird, umfasst.

4. Vorrichtung zur Zuführung elektromagnetischer Energie in eine Lösung, wie in einem der vorhergehenden Ansprüche beansprucht, welche eine Zener-Diode zum Regulieren der über das Oszillatorkristallmittel angelegten Spannung umfasst.

5. Vorrichtung zur Zuführung elektromagnetischer Energie in eine Lösung, wie in einem der vorhergehenden Ansprüche beansprucht, welche einen Pufferchip zum Regulieren der Abgabe des Oszillatorkristallmittels zu der Antenne umfasst.

6. Vorrichtung zur Zuführung elektromagnetischer Energie in eine Lösung, wie in einem der vorhergehenden Ansprüche beansprucht, welche einen Schalter und ein separates Mittel zur Anzeige dessen, wenn die Vorrichtung in Betrieb ist, umfasst.

7. Vorrichtung zur Zuführung elektromagnetischer Energie in eine Lösung, wie in einem der vorhergehenden Ansprüche beansprucht, welche eine oder mehrere Dioden umfasst, um zuzulassen, dass Strom in einer Richtung fließt, und um eine aufladbare Batterie vor unsachgemäßem Aufladen zu schützen.

8. Vorrichtung zur Zuführung elektromagnetischer Energie in eine Lösung, wie in einem der vorhergehenden Ansprüche beansprucht, wobei die Antenne mit einer Messingkugel an ihrem Ende und einem optionalen Abdeckelement versehen ist.

9. Vorrichtung zur Zuführung elektromagnetischer Energie in eine Lösung, wie in einem der vorhergehenden Ansprüche beansprucht, welche einen Filter zum Reduzieren oder Eliminieren sekundärer oder tertiärer Harmonischer aus der Abgabe des erzeugten Signals umfasst.

10. Vorrichtung zur Zuführung elektromagnetischer Energie in eine Lösung, wie in einem der vorhergehenden Ansprüche beansprucht, wobei die Antenne entlang der Innenseite einer zur Zufuhr von Wasser verwendeten Rohrleitung angeordnet werden kann.

11. Vorrichtung zur Zuführung elektromagnetischer Energie in eine Lösung, wie in Anspruch 10 beansprucht, wobei die Wasserleitung Wasser zur Bewässerung von Pflanzen, wie etwa Gras, Früchten, Gemüse, Blüten, Gehölzen und Bäumen, zuführt.

12. Vorrichtung zur Zuführung elektromagnetischer Energie in eine Lösung, wie in Anspruch 9 beansprucht, wobei die Wasserleitung Wasser zur Nutzung in Haushaltsanwendungen zuführt, wobei die Vorrichtung hilft, Kalkniederschlag in Wasserkochern, Kaffeemaschinen, Wasserhähnen, Mischhähnen, Duschköpfen und dergleichen zu verhindern oder zu eliminieren.

13. Vorrichtung zur Zuführung elektromagnetischer Energie in eine Lösung, wie in einem der Ansprüche 9 bis 12 beansprucht, wobei der Filter betreibbar ist, um die Abgabefrequenz auf einem konstanten Wert im Bereich von 27.225 MHz bis 27.255 MHz zu halten.

14. Verfahren zur Behandlung von Wasser durch Zuführung elektromagnetischer Energie in das Wasser unter Verwendung einer Vorrichtung, wie in einem der vorhergehenden Ansprüche beansprucht.

## Revendications

1. Appareil pour la distribution d'une énergie électromagnétique dans une solution, comprenant :
une source d'alimentation;
un oscillateur à cristal pour générer un signal électromagnétique tel qu'un signal radioélectrique (RF);
une antenne pour la transmission dans la solution du signal généré, **caractérisé en ce que** l'antenne est un fil métallique allongé dont la longueur représente approximativement 1/16 de la longueur d'onde du signal RF généré par l'oscillateur à cristal.

2. Appareil pour la distribution d'une énergie électromagnétique dans une solution selon la revendication 1, dans lequel la source d'alimentation est choisie parmi une des suivantes :
un accumulateur;
un adaptateur au secteur de courant continu;
une batterie rechargeable;
une batterie rechargeable avec une batterie de secours; et
une batterie rechargeable avec une génératrice de courant continu de l'alimenter par un courant d'eau.

3. Appareil pour la distribution d'une énergie électromagnétique dans une solution selon la revendication 2, qui englobe un moyen pour indiquer qu'une batterie est en charge lorsqu'une batterie rechargeable est utilisée comme source d'alimentation.

4. Appareil pour la distribution d'une énergie électromagnétique dans une solution selon l'une quelconque des revendications précédentes, englobant une diode zener pour réguler la tension appliquée sur l'oscillateur à cristal.

5. Appareil pour la distribution d'une énergie électromagnétique dans une solution selon l'une quelconque des revendications précédentes, englobant une puce tampon pour réguler la sortie de l'oscillateur à cristal en direction de l'antenne.

6. Appareil pour la distribution d'une énergie électromagnétique dans une solution selon l'une quelconque des revendications précédentes, englobant un commutateur et un moyen séparé pour indiquer l'état de marche de l'appareil.

7. Appareil pour la distribution d'une énergie électromagnétique dans une solution selon l'une quelconque des revendications précédentes, englobant une ou plusieurs diodes pour permettre au courant de circuler dans une direction et pour protéger une batterie rechargeable contre une charge inappropriée.

8. Appareil pour la distribution d'une énergie électromagnétique dans une solution selon la revendication 7, dans lequel l'antenne est munie d'une boule en laiton à son extrémité et d'un élément de recouvrement facultatif.

9. Appareil pour la distribution d'une énergie électromagnétique dans une solution selon l'une quelconque des revendications précédentes, englobant un filtre pour réduire ou pour éliminer les deuxièmes ou les troisièmes harmoniques de la sortie du signal généré.

10. Appareil pour la distribution d'une énergie électromagnétique dans une solution selon l'une quelconque des revendications précédentes, dans lequel l'antenne peut venir se disposer à l'intérieur d'un tuyau utilisé pour l'alimentation d'eau.

11. Appareil pour la distribution d'une énergie électromagnétique dans une solution selon la revendication 10, dans lequel le tuyau pour l'eau distribue de l'eau pour l'irrigation de plantes vivantes telles que de l'herbe, des fruits, des légumes, des fleurs, des arbrisseaux et des arbres.

12. Appareil pour la distribution d'une énergie électromagnétique dans une solution selon la revendication 9, dans lequel le conduit pour l'eau distribue de l'eau à utiliser dans des applications domestiques, l'appareil favorisant le fait d'empêcher ou d'éliminer la formation de tartre dans des bouilloires, dans des machines à café, dans des robinets, dans des pommes de douche et analogues.

13. Appareil pour la distribution d'une énergie électromagnétique dans une solution selon l'une quelconque des revendications 9 à 12, dans lequel le filtre peut être mis en service pour maintenir la fréquence de sortie à une valeur constante dans la plage de 27,225 MHz à 27,255 MHz.

14. Procédé pour traiter l'eau en distribuant de l'énergie électromagnétique dans l'eau via l'utilisation d'un appareil tel que revendiqué dans l'une quelconque des revendications précédentes.
